(19) **Europäisches Patentamt**

**European Patent Office**

**Office européen des brevets**

(11) **EP 0 944 962 B1**

(12) **EUROPÄISCHE PATENTSCHRIFT**

(45) Veröffentlichungstag und Bekanntmachung des Hinweises auf die Patenterteilung:
**02.03.2005 Patentblatt 2005/09**

(51) Int Cl.7: **H03M 13/00**

(21) Anmeldenummer: **97913067.1**

(22) Anmeldetag: **26.11.1997**

(86) Internationale Anmeldenummer:
**PCT/CH1997/000442**

(87) Internationale Veröffentlichungsnummer:
**WO 1998/026508 (18.06.1998 Gazette 1998/24)**

(54) **VERFAHREN UND SCHALTUNGSANORDNUNG ZUR DECODIERUNG EINES ZYKLISCH CODIERTEN SIGNALS**

METHOD AND CIRCUIT FOR DECODING A CYCLICALLY CODED SIGNAL

PROCEDE ET CIRCUIT POUR LE DECODAGE D'UN SIGNAL CODE CYCLIQUEMENT

(84) Benannte Vertragsstaaten:
**AT BE CH DE DK ES FI FR GB IT LI NL SE**

(30) Priorität: **12.12.1996 CH 304896**

(43) Veröffentlichungstag der Anmeldung:
**29.09.1999 Patentblatt 1999/39**

(73) Patentinhaber: **Siemens Schweiz AG**
**8047 Zürich (CH)**

(72) Erfinder: **HABERMACHER, Thomas**
**CH-5200 Brugg (CH)**

(74) Vertreter: **Berg, Peter, Dipl.-Ing. et al**
**European Patent Attorney,**
**Siemens AG,**
**Postfach 22 16 34**
**80506 München (DE)**

(56) Entgegenhaltungen:
**EP-A- 0 159 403       EP-A- 0 183 549**
**EP-A- 0 596 340       WO-A-95/12849**
**DE-A- 4 203 301       DE-A- 4 338 247**

- **PATENT ABSTRACTS OF JAPAN vol. 96, no. 10, 31.Oktober 1996 & JP 08 163101 A (TOSHIBA), 21.Juni 1996,**

**Beschreibung**

Bei Übertragungssystemen, durch die innerhalb einer kurzen zur Verfügung stehenden Zeit grosse Datenmengen zu übertragen sind, ist es von grosser Bedeutung, dass auftretende Bitfehler die Übertragung der Information nicht gefährden. Besondere Bedeutung gewinnt diese Forderung bei Übertragungssystemen, die aus der Verkehrstechnik bekannt sind. In H. Ernst, EURO-Balise S21-Meilenstein für das ETCS, Eisenbahntechnische Rundschau 45 (1996), Heft 10, Seiten 617 - 622 wird eine wesentliche Komponente des europäischen Zugbeeinflussungssystems ETCS (European Train Control Systems), nämlich das Subsystem Balise beschrieben. Eine Balise dient dabei zur Übertragung von Telegrammen von einem Streckenpunkt über eine Luftspaltschnittstelle zu Empfangsstationen, die auf vorbeifahrenden Fahrzeugen angeordnet sind (oft ist auch eine bidirektionale Datenübertragung vorgesehen). Aufgrund der geringen Kontaktlänge, innerhalb der Daten von der Balise zum Fahrzeugempfänger übertragen werden, wird beim Subsystem Balise auch von einer punktförmigen Übertragung gesprochen. Bei hohen Geschwindigkeiten der verkehrenden Fahrzeuge und der geringen Kontaktlänge stehen für die Datenübertragung nur wenige Millisekunden zur Verfügung. Eine zyklische Codierung der Daten ergibt gegenüber der Blockcodierung die Möglichkeit, mitten in einem laufenden Datenstrom mit der Decodierung zu beginnen und nach einer Telegrammlänge das Telegramm zu decodieren. Dies erlaubt, die zur Verfügung stehende Übertragungszeit gut zu nutzen. Beim Auftreten eines Bitfehlers kann der Empfang des Telegramms, das während einer gewissen Zeit wiederholt unverändert ausgesendet wird, mit dem nächsten eintreffenden Datenbit, wiederum inmitten des gerade empfangenen Telegramms, wieder beginnen. Obwohl der Neubeginn verzögerungslos inmitten eines Telegramms wieder beginnen kann, gehen unter Umständen grössere Datenmengen verloren. Falls eines der Datenbits des empfangenen Telegramms, z.B. schon das erste Bit von 1023 Bits, fehlerhaft war, werden n-1 korrekt empfangene Bit verworfen. Bei längeren Telegrammen und der Wahl kurzer Kontaktzeiten kann daher bereits bei wenigen Übertragungsfehlern die Übertragung der Information scheitern.

Aus der EP 0 541 161 A2 ist ein System zur Übertragung zyklisch codierter Daten bekannt. Bei diesem System werden jedoch nicht über längere Zeit dieselben Telegramme ausgesandt, von denen in der Empfangseinheit mit hoher Wahrscheinlichkeit wenigstens ein einzelnes fehlerfrei empfangen werden soll. Dieses System soll hingegen auf einfache Weise sowohl die Korrektur von Bündelfehlern, als auch die Korrektur von Einzelfehlern in den Telegrammen ermöglichen, die nur einmal übertragen werden. Unter Umständen bleibt ein fehlerhaftes Telegramm jedoch unkorrigiert, wodurch dessen Information verloren geht. Dies ist z.B. bei der Bildübertragung von untergeordneter Bedeutung. Bei der Datenübertragung in verkehrstechnischen Systemen ist die sichere Übertragung von Daten hingegen von grösster Bedeutung. Selbst bei kurzen Kontaktzeiten zwischen Sender und Empfänger von wenigen Millisekunden soll wenigstens ein Telegramm, das die benötigte Information enthält, mit hoher Wahrscheinlichkeit korrekt übertragen und empfangen werden.

Beim in EP 0 790 710 B1 offenbarten Verfahren wird durch Bildung eines Syndroms geprüft, ob der Inhalt eines Telegramms fehlerfrei übertragen wird. Mit dem Begriff Syndrom - auch "Rest" genannt - ist die Funktion (c(x) mod g(x)) bezeichnet, dabei steht c(x) für das Produkt eines Datenwortes d(x) mit einem Generatorpolynom g(x). Eine zyklische Codierung bedeutet, dass das Generatorpolynom g(x) ein Faktor des Polynoms $x^n$ - 1 ist. Beim in EP 0 790 710 B1 offenbarten Verfahren wird beim rückgekoppelten Schieberegister der interne Registerzustand richtiggestellt bevor nachfolgende Datenbits in das Schieberegister hineingetaktet werden. Dazu ist erforderlich, dass frühere Datenbits zwischengespeichert werden müssen. Dies ist mit einem erheblichen Speicher- und Transferaufwand verbunden. den soll wenigstens ein Telegramm, das die benötigte Information enthält, mit hoher Wahrscheinlichkeit korrekt übertragen und empfangen werden.

Der vorliegenden Erfindung liegt daher die Aufgabe zugrunde, ein Verfahren und eine Schaltungsanordnung anzugeben, die es erlauben, innerhalb von kurzen Kontaktzeiten längere Telegramme sicher zu übertragen.

Diese Aufgabe wird durch die im des Patentanspruchs 1 angegebenen Massnahmen gelöst. Vorteilhafte Ausgestaltungen der Erfindung sind in weiteren Ansprüchen angegeben.

Das erfindungsgemässe Verfahren erlaubt die Übertragung von längeren Telegrammen, die empfangsseitig auf besonders vorteilhafte Weise decodiert und geprüft werden. Die Decodierung und Fehlerprüfung erfolgt praktisch in Echtzeit, so dass keine Verzögerungen entstehen, die in einem Fehlerfall zu weiteren Datenverlusten führen könnten. Durch die Berücksichtigung bereits früher eingetroffener Daten kann die Fehlerprüfung jeweils mit einem Rechenschritt erfolgen, wodurch die Datenrate der in Echtzeit zu bearbeitenden Daten sehr hoch gewählt werden kann. Die Aussage bezüglich der Korrektheit eines übertragenen Telegramms kann daher unmittelbar nach Empfang des letzten Datenbits des Telegramms sowie nach einem zusätzlichen Rechenschritt erfolgen. Durch die optimale Ausnutzung der übertragenen Informationen, werden Datenverluste, die beim Auftreten eines Fehlers entstehen können, auf ein Minimum reduziert.

Die Erfindung wird nachfolgend anhand einer Zeichnung beispielsweise näher erläutert. Dabei zeigt:

Fig. 1    ein Datenübertragungssystem mit Nachrichtenquelle und Nachrichtensenke,
Fig. 2    eine zur zyklischen Codierung eines Datensignals dienende, bekannte Schaltungsanordnung,

Fig. 3 ein Signal, welches der in Fig. 2 gezeigten Schaltungsanordnung zugeführt wird,

Fig. 4 ein codiertes Signal,

Fig. 5 eine erfindungsgemässe Schaltungsanordnung zur Decodierung des übertragenen Signals,

Fig. 6 die in Fig. 5 gezeigte Schaltungsanordnung ergänzt durch eine Schaltungsanordnung, die zur Synchronisation der Telegramme dient und

Fig. 7 ein zur Synchronisation der Telegramme vorgesehenes Schieberegister.

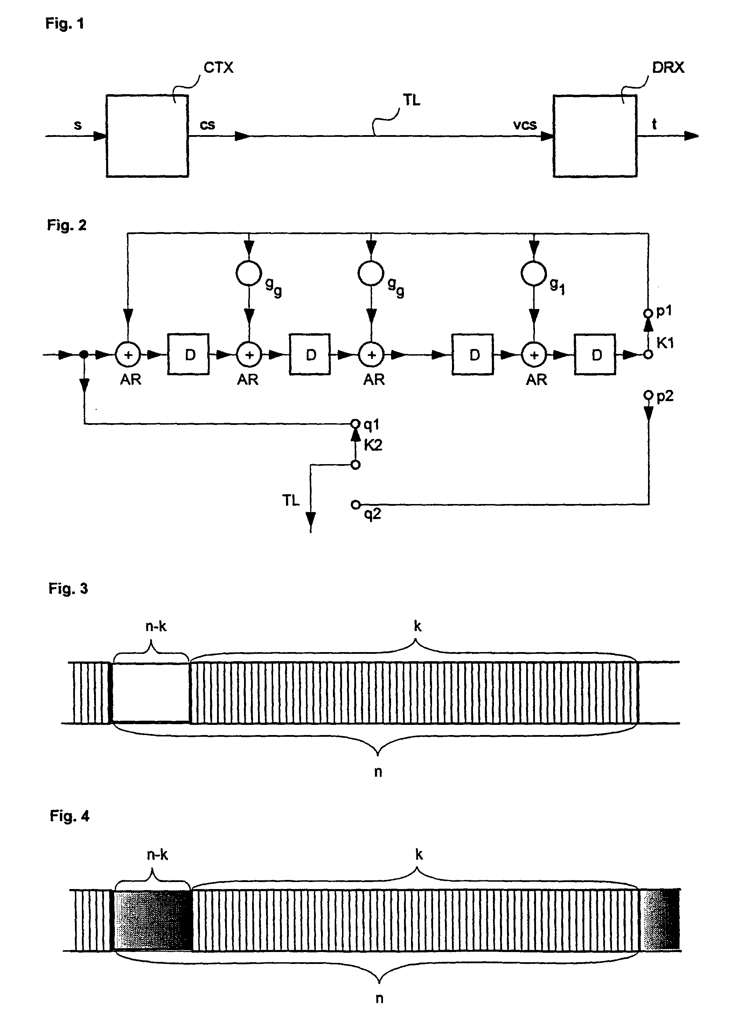

Fig. 1 zeigt ein Übertragungssystem mit einer eine Codierschaltung aufweisenden Sendeeinheit CTX, die über eine leitungsgebundene oder eine nicht leitungsgebundene Übertragungsstrecke TL, z.B. eine Übertragungsleitung oder eine Luftspaltschnittstelle, mit einer eine Decodierschaltung aufweisenden Empfangseinheit DRX verbunden ist. Der Sendeeinheit CTX wird ein Informationssignal s zugeführt, das aus einer Serie sich zyklisch wiederholender Telegramme besteht, oder aus dem eine in der Sendeeinheit CTX eine Serie sich zyklisch wiederholender Telegramme erstellt wird, wie sie in Fig. 3 vor deren Codierung bzw. in Fig. 4 nach deren Codierung dargestellt sind. Am Ausgang der Sendeeinheit CTX wird daher das zu übertragende, codierte Signal cs abgegeben, das über die Übertragungsstrecke TL gegebenenfalls verzerrt und mit Störungen überlagert dem Eingang der Empfangseinheit DRX zugeführt wird. Am Eingang der Empfangseinheit DRX liegt daher das zu decodierende und gegebenenfalls zu entzerrende Signal vcs an. In der Empfangseinheit DRX werden aus dem zugeführten Signal vcs durch Entzerrung, Taktregenerierung, Decodierung und Fehlerprüfung sowie gegebenenfalls Fehlerkorrektur korrekte Telegramme t extrahiert und z.B. zur Verwertung an einen Fahrzeugrechner abgegeben.

Fig. 2 zeigt eine aus R. C. Dorf, The Electrical Engineering Handbook, CRC Press, Boca Raton 1993, Seite 1406, Fig. 64.2 bekannte Schaltungsanordnung, die zur zyklischen Codierung eines Datensignals bzw. des in Fig. 3 gezeigten Datensignals dient, das aus k Datenbits und n-k Bits einer unveränderlichen Bitkombination also insgesamt n Bits besteht, die repetitiv zu übertragen sind. Die k Datenbits bleiben vorzugsweise über längere Zeit unverändert, da z.B. streckenseitig von einer Leitstelle oder von lokalen Meldevorrichtungen immer dieselbe Zustandsinformation abgegeben wird. Empfangsseitig genügt es in diesem Fall, wenn aus mehreren identischen Telegrammen ein einzelnes korrekt extrahiert werden kann. Die unveränderlichen n-k Bits weisen z.B. alle den Wert "0" auf. Beispielsweise liegt an der Sendeeinheit CTX permanent die in den k Datenbits enthaltene Information an. Aus dieser Information ist in der Sendeeinheit CTX vor der Codierung das in Fig. 3 gezeigte Telegramm mit k Datenbits und n-k Bits z.B. vom Wert "0" zu bilden und repetitiv der in Fig. 2 gezeigten Codierschaltung zuzuführen, die nach Empfang der k Datenbits durch die n-k unveränderlichen Bits jeweils wieder initialisiert wird. Die Codierschaltung weist n-k binäre Schieberegister- oder Speicherzellen auf und erlaubt die zyklische Codierung der zu übertragenden Telegramme mit einem systematischen Code durch das Generatorpolynom

$$g(x) = x^{n-k} + g_1\, x^{n-k-1} + ... + g_{n-k-1}\, x + 1.$$

Die Werte von g1, ..., $g_{n-k-1}$ sind entweder "0" oder "1". Der Codiervorgang verläuft, wie in Frank J. Furrer, Fehlerkorrigierende Block-Codierung für die Datenübertragung, Birkhäuser Verlag, Basel 1981, auf Seiten 99 - 126 beschrieben (siehe insbesondere Seiten 121 und 122), in zwei sequentiell ablaufenden Phasen :

1. Phase : Die Schaltkontakte K1 und K2 sind in Position p1 bzw. q1. Die k Informationsbit werden ins Schieberegister eingelesen und gleichzeitig der Übertragungsstrecke TL zugeführt. Während der Dauer dieser ersten Phase bzw. während k Taktimpulsen werden alle k Informationsbit der Übertragungsstrecke TL zugeführt. Gleichzeitig werden im Schieberegister die n-k Kontrollbit gebildet.

2. Phase: Die Schaltkontakte K1 und K2 sind in Position p2 bzw. q2. Während der Dauer dieser zweiten Phase bzw. während n-k Taktimpulsen werden alle n-k Kontrollbit der Übertragungsstrecke TL zugeführt. Gleichzeitig wird das Schieberegister mit der in Fig. 3 gezeigten konstanten Bitkombination gefüllt, die z.B. aus n-k Bits vom Wert "0" besteht. Nach Abschluss der zweiten Phase und vor Wiederbeginn der ersten Phase sind daher alle n-k Kontrollbit der Übertragungsstrecke TL zugeführt. Die Schieberegisterzellen sind in dem beschriebenen Beispiel mit Bits vom Wert "0" gefüllt. Das aus n Daten- und Kontrollbits bestehende codierte Telegramm, welches in Fig. 4 dargestellt ist, wurde der Übertragungsstrecke TL zugeführt. Vor Wiederbeginn der ersten Phase werden die Schaltkontakte K1 und K2 auf die Positionen p1 bzw. q1 zurückgesetzt.

Das in Fig. 4 dargestellte, aus n Daten- und Kontrollbits bestehende codierte Telegramm, welches ein Codewort des verwendeten zyklischen Codes ist, wurde nach Abschluss der zweiten Phase über die Übertragungsstrecke TL der Empfangseinheit DRX zugeführt. Gemäss einem herkömmlichen Prüfverfahren wird das empfangene Telegramm durch das Generatorpolynom dividiert. Ist das Syndrom (=Rest) gleich null, so liegt ein gültiges Telegramm vor.

Diese Division lässt sich bei längeren Codewörtern bzw. Telegrammen nur sequentiell in mehreren Schritten durchführen. Besteht ein Telegramm aus n Bits, so muss die Division n-fach ausgeführt werden, bevor entschieden werden kann, ob ein gültiges Telegramm vorliegt. Pro Taktzyklus bei der Datenübertragung sind daher n Rechenoperationen auszuführen, wenn nach Empfang jedes eintreffenden Bits ein Entscheid auf Richtigkeit erforderlich ist. Schon bei relativ tiefen Datenübertragungsraten ist eine Verarbeitung der empfangenen Daten in Echtzeit nicht mehr möglich. Dieser Mangel wird mit dem erfindungsgemässen Verfahren beseitigt.

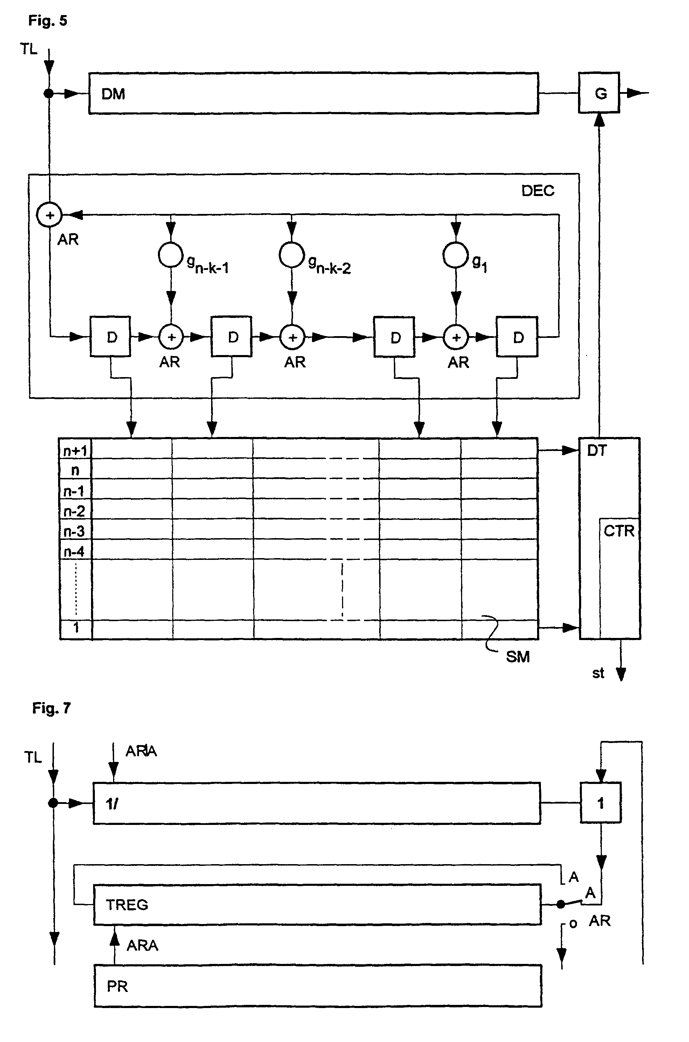

Das erfindungsgemässe Verfahren wird anhand einer Empfangseinheit DRX in Fig. 5 beschrieben. Die Empfangseinheit DRX enthält im wesentlichen die in Fig. 5 dargestellte Schaltungsanordnung, die einen Datenspeicher DM, eine Decodierschaltung DEC, einen Syndromspeicher SM sowie eine mit einem Tor G verbundene Differenzstufe DT aufweist. Die über die Übertragungsstrecke TL übertragenen Daten werden sowohl dem Datenspeicher DM, als auch der Decodierschaltung DEC zugeführt, welche über n-k Ausgänge mit dem Syndromspeicher SM verbunden ist (Der Wert n-k entspricht dem Grad des Generatorpolynoms g(x)). In der Decodierschaltung DEC erfolgt, analog zu der in Fig. 2 dargestellten Codierschaltung, eine systematische Decodierung anhand des Generatorpolynoms

$$g(x) = x^{n-k} + g_1\, x^{n-k-1} + ... + g_{n-k-1}\, x + 1,$$

wobei nach jedem Taktimpuls bzw. nach jedem Einschieben eines Bits des übertragenen Telegramms in das in der Decodierschaltung DEC vorgesehene Schieberegister, das in den Schieberegisterzellen D enthaltene n-k Stellen aufweisende Syndrom $S_g$ dem Syndromspeicher SM zugeführt wird, der sequentiell vorzugsweise n+1 Syndrome $S_g$ aufnehmen kann und diese z.B. in einer Tabelle zeilenweise ablegt und nach dem first in-first out-Prinzip weiter verschiebt.

Bei der Übertragung von identischen Telegrammen wird nach der Übertragung von n Datenbits bzw. nach einem vollständigen Telegramm mit dem ersten Datenbit des nächstfolgenden Telegramms durch die Decodierschaltung DEC wieder ein Syndrom $S_{g\,n+1}$ gebildet, das identisch zum ersten Syndrom $S_{g\,1}$ des letzten Telegramms ist, sofern die letzten n Datenbits korrekt übertragen wurden. Über zwei Ausgänge des Syndromspeichers SM sind der Differenzstufe DT daher das zuletzt und das n Taktzyklen früher abgespeicherte Syndrom $S_{g\,1}$ bzw. $S_{g\,n+1}$ zuführbar. Sofern die in der Differenzstufe DT gebildete Differenz zwischen den Syndromen $S_{g\,1}$ sowie $S_{g\,n+1}$ gleich null ist, wird das Tor G durch ein Ausgangssignal der Differenzstufe DT geöffnet, wonach die als korrekt festgestellten n Datenbits aus dem Datenspeicher DM ausgelesen werden. Die Überprüfung der Syndrome $S_g$ durch die Differenzstufe DT kann mit jedem Taktimpuls erfolgen, so dass mit jedem Taktimpuls festgestellt werden kann, ob die letzten n Datenbits korrekt empfangen wurden. Wesentlich ist ferner, dass keine Verzögerungen durch die zu leistende Rechenarbeit entsteht, da für jedes der zuletzt empfangenen 1, ..., n Datenbits ein Syndrom $S_{g\,1}, ...S_{g\,n}$ bereits berechnet und abgespeichert ist. Aufgrund der Berücksichtigung der bereits berechneten und abgespeicherten Syndrome $S_{g\,1}, ...S_{g\,n}$ ist mit jedem Taktimpuls nur ein einzelnes Syndrom $S_{g\,1}$ zu bilden und mit einem früher abgespeicherten Syndrom $S_{g\,n+1}$ zu vergleichen. Dieser relativ geringe Rechenaufwand kann selbst bei hohen Datenübertragungsraten in Echtzeit erfolgen.

Die ausgelesenen 1, ..., n Datenbits entsprechen einem vollständigen Telegramm, das nicht korrekt zusammengesetzt ist, falls das erste aus dem Datenspeicher DM ausgelesene Datenbit nicht dem ersten Bit des Telegramms entspricht. Dies ist normalerweise der Fall, da bei zyklischer Codierung, wie in H. Ernst, EURO-Balise S21-Meilenstein für das ETCS, a.a.O., Seite 621 beschrieben, die Decodierung mitten in einem laufenden Datenstrom und somit auch an beliebiger Stelle innerhalb eines Telegramms beginnen kann. Die Massnahmen, die es erlauben ein derart decodiertes Telegramm wieder korrekt zusammenzusetzen, sind in der a.a.O., Seite 121 erwähnten Form Fit Function Specification (Coding Strategy) für die Euro-Balise (Issue 2.0.0, 21/12-95, Distribution : Eurosig, EC, UIC) beschrieben. Zur Codierung wird dazu ein Generatorpolynom t(x) verwendet, das wie folgt gebildet wird :

$$t(x) = f(x) \cdot g(x)$$

Die Polynome g(x) und f(x) weisen den Grad v bzw. w auf, wodurch sich ein Grad von n-k (n-k = v + w) für t(x) ergibt. Nach der Codierung bzw. CRC-Bildung wird zum codierten Telegramm das Polynom g(x) addiert :

## das codierte Telegramm

| | n | |
|---|---|---|
| k | | n-k |
| Daten | | CRC |

## plus das Polynom g(x)

## ergibt das zu übertragende Telegramm

| Daten | $CRC_{syn}$ |
|---|---|

Die Decodierung bezüglich g(x) ist daher fehlerfrei, da die Teilbarkeit durch g(x) auch nach der erfolgten Addition mit dem Polynom g(x) noch gewährleistet ist (die Differenz der anhand des Polynoms g(x) gebildeten Syndrome $S_{g\,1}$ und $S_{g\,n+1}$ ist null). Die Decodierung bezüglich f(x) ist jedoch nicht fehlerfrei (die Differenz der anhand des Polynoms f(x) gebildeten Syndrome $S_{f\,1}$ und $S_{f\,n+1}$ ist nicht null). Innerhalb des $CRC_{syn}$ entsteht bei der Decodierung mit dem Polynom f(x) an festgelegten Stellen eine festgelegte Anzahl Fehlerbits (↓↓↓) :

| Daten | $CRC_{syn}$ ↓↓↓ |
|---|---|

Nach dem erfindungsgemässen Verfahren werden aus dem Syndromspeicher SM die Syndrome $S_{g\,1}$ und $S_{g\,n+1}$ ausgelesen, die nach dem Eintreffen des ersten und des n-plus-ersten Bits anhand des Generatorpolynoms g(x) gebildet wurden und deren Differenz gleich null ist, falls die dazu korrespondierenden 1, ..., n Datenbits korrekt übertragen wurden. Bei Decodierung der übertragenen Codeworte des Polynoms f(x) entspricht die Differenz der Syndrome $S_{f\,1}$ und $S_{f\,n+1}$, die zu 1, ..., n übertragenen Datenbits korrespondieren, einem Wert ungleich null, der bei einem beispielsweise gewählten Grad w = 10 für das Polynom f(x) im Bereich von 1 bis $(2^{w2}-1)$ bzw. im Bereich von 1 bis 1023 liegt. Dieser Bereich entspricht vorzugsweise der Telegrammlänge n. Der Wert 0 entfällt aufgrund der Tatsache, dass nach der sendeseitigen Addition des Polynoms g(x) die Differenz der anhand des Polynoms f(x) gebildeten Syndrome $S_{f\,1}$ und $S_{f\,n+1}$ immer ungleich null ist. Anhand des ermittelten Wertes kann die Position des Fehlers innerhalb der aus dem Datenspeicher DM ausgelesenen n Datenbits z.B. anhand einer Tabelle ermittelt werden, die rechnerisch oder anhand von Erfahrungswerten erstellt wurde. Ein nicht korrekt zusammengesetztes Telegramm, das ansonsten in bezug auf die Decodierung mit dem Polynom g(x) fehlerfrei ist,

| Daten | $CRC_{syn}$ ↓↓↓ | Daten |
|---|---|---|

kann aufgrund der ermittelten Position der in bezug auf die Decodierung mit dem Polynom f(x) festgestellten Fehler (↓↓↓) und unter Berücksichtigung der bekannten Sollposition der Fehler (↓↓↓) daher wieder korrekt zusammengefügt werden :

| Daten | $CRC_{syn}$ ↓↓↓ |
|---|---|

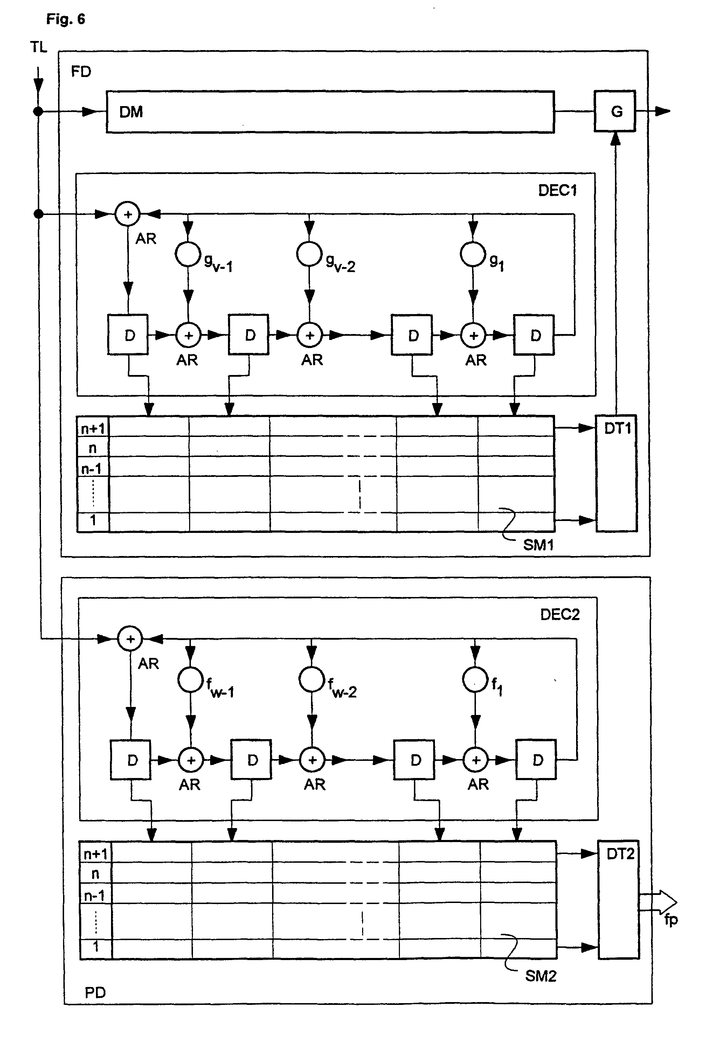

Die in Fig. 6 dargestellte Schaltungsanordnung, die zwei Module FD und PD aufweist, erlaubt die Erkennung und Synchronisierung korrekt übertragener Telegramme. Die Übertragungsstrecke TL ist einerseits mit dem ersten zur Fehlererkennung vorgesehenen Modul FD und andererseits mit dem zweiten der Synchronisation dienenden Modul PD verbunden. Das erste Modul FD weist einen Datenspeicher DM, ein Tor G, einen Decoder DEC1, einen Syndromspeicher SM1 und eine Differenzstufe DT1 auf, die wie die entsprechenden Bauteile in der in Fig. 5 gezeigten Schaltungsanordnung miteinander verbunden sind und dieselben Funktionen aufweisen. Der Decoder DEC1 und der Syndromspeicher SM1 sind ebenfalls dem Grad des Polynoms g(x) angepasst und weisen die diesem Grad entsprechende

**EP 0 944 962 B1**

Anzahl (v) Speicherzellen (pro Zeile) auf. Zur Synchronisation von Telegrammen, die als korrekt erkannt wurden, dient das Modul PD, das einen weiteren Decoder DEC2 sowie einen mit einer zweiten Differenzstufe DT2 verbundenen zweiten Syndromspeicher SM2 aufweist. Die Funktion und Zusammenschaltung dieser Bauteile DEC2, SM2 und DT2 entspricht derjenigen des Moduls FD. Die über die Übertragungsstrecke TL2 zugeführten Telegramme werden im zweiten Decoder DEC2 anhand des Polynoms f(x) decodiert, wonach die schrittweise gebildeten Syndrome $S_f$ zeilenweise in den Syndromspeicher SM2 eingelesen werden. Der Decoder DEC2 und der Syndromspeicher SM2 sind ebenfalls dem Grad des verwendeten Polynoms, f(x), angepasst und weisen die entsprechende Anzahl, w, Speicherzellen auf. Der Inhalt der ersten und der n plus ersten Zeile des zweiten Syndromspeichers SM2 ist ebenfalls der zweiten Differenzstufe DT2 zuführbar, in der die Differenz fp der vorliegenden Syndrome $S_f$ gebildet wird, die aus den obenerwähnten Gründen bei als korrekt erkannten Telegrammen nie gleich null ist und die anzeigt, an welcher Stelle des Telegramms der erwartete Fehler liegt. Die berechnete Differenz fp wird z.B. einer Steuereinheit (z.B. einem Prozessor (MP, DSP) oder einem programmierten Logik-Array) zugeführt, der die Differenz zwischen der Stelle, an der der Fehler lokalisiert wurde und der Stelle, an der der Fehler in bereits synchronisierten Telegramm auftreten sollte bzw. zu der der festgestellte Fehler weiter zu schieben ist, berechnet. Wie in Fig. 7 beispielsweise dargestellt ist, hat die Steuereinheit PR zu diesem Zweck Zugang zu einem Register TREG, in das das korrekt decodierte Telegramm eingelesen und innerhalb dem das Telegramm um die berechnete Anzahl Stellen zyklisch verschoben werden kann. In Fig. 7 ist der Schaltkontakt K3 zum Einlesen der Daten in Position i, zum Rotieren der Daten in Position s und zum Ausgeben der Daten in Position o. Das Einlesen der Daten in das Datenregister DM erfolgt mit dem Taktsignal tkt1, das aus dem empfangenen Signal regeneriert wurde. Die zyklische Verschiebung bzw. Rotation des im Register TREG enthaltenen Telegramms erfolgt mit dem von der Steuereinheit PR abgegebenen Taktsignal tkt2 um die betreffende Anzahl Takte. Die Schaltung von Fig. 7 hat den Vorteil, dass der Datenspeicher DM nach dem Auslesen des Telegramms bereits wieder mit neuen Daten gefüllt werden kann. Grundsätzlich kann die Rotation des Telegramms jedoch auch innerhalb dem Datenspeicher DM erfolgen, so dass auf das Register TREG verzichtet werden kann. Ferner kann nebst rein seriellen Schieberegistern auch ein Barrel-Shifter verwendet werden. Die Syndromspeicher SM1, SM2 sowie gegebenenfalls auch der Datenspeicher DM können Bestandteil einer einzigen Speichereinheit sein, zu der die Steuereinheit PR Zugriff hat. Die Funktionen der Differenzstufen DT, DT1 und DT2 können ferner durch die Steuereinheit PR wahrgenommen werden.

In Fig. 5 ist ferner ein vorzugsweise in die Differenzstufe DT (oder in eine entsprechende Steuereinheit) integrierter Zähler CTR vorgesehen, der beim erstmaligen Erkennen eines gültigen Telegramms (die In Fig. 5 ist ferner ein vorzugsweise in die Differenzstufe DT (oder in eine entsprechene Steuereinheit) integrierter Zähler CTR vorgesehen, der beim erstmaligen Erkennen eines gültigen Telegramms (die Differenz der anhand des Polynoms g(x) gebildeten Syndrome $S_{g\,1}$ und $S_{g\,n+1}$ ist null) initialisiert und mit dem Eintreffen jedes weiteren gültigen Datenbits ($S_{g\,2}$ und $S_{g\,n+2}$ ist null, etc.) hochgezählt wird (beim Auftreten eines Fehlers wird der Zähler CTR hingegen zurückgesetzt). Dadurch kann die Länge des Übertragungsfensters (Übertragungsfenster = Telegrammlänge n + Endzählerstand x) bestimmt werden. Falls das gemessene Übertragungsfenster von dem in Abhängigkeit der vorliegenden Parameter (Fahrzeuggeschwindigkeit, etc.) zu erwartenden Übertragungsfenster in unzulässiger Weise abweicht, wird vorzugsweise vom Fahrzeug eine Fehlermeldung an die zugehörige Leitstelle abgegeben, so dass Korrekturmassnahmen vorgenommen werden können. Die Meldung kann z.B. über Funk oder, sofern eine bidirektionale Datenübertragung vorgesehen ist, bei der nächsten Balise erfolgen.

Zusätzliche Übertragungssicherheit lässt sich gewinnen, indem das Öffnen des Tores G mit dem Erreichen eines bestimmten Zählerstandes m verknüpft wird. Die Öffnung des Tores G erfolgt erst nach n plus m (m <= x; z.B. m = n / 5) korrekt empfangenen Datenbits.

### Liste der verwendeten Abkürzungen

| ETCS | European Train Control System |
|------|-------------------------------|
| UIC | Union Internationale des Chemins de fer |

### Liste der verwendeten Bezugszeichen

| CRC | Cyclic Redundancy Check |
|-----|-------------------------|
| CTR | Zähler, Counter |
| CTX | Sendeeinheit |
| cs | codiertes Signal |

| | |
|---|---|
| DEC | Decodierschaltung, Decoder |
| DM | Datenspeicher |
| DSP | Digitaler Signalprozessor |
| DT | Differenzstufe |
| DRX | Empfangseinheit |
| G | Tor, Gate |
| FD | Modul zur Fehlererkennung |
| K1, K2, K3 | Schaltkontakte |
| MP | Mikroprozessor |
| PD | Modul zur Synchronisation |
| PR | Steuereinheit |
| p1 | Position der Schaltkontakte K1, K2 |
| q2 | Position der Schaltkontakte K1, K2 |
| SM | Syndromspeicher |
| TL | Übertragungsstrecke |
| TREG | Register |
| vcs | zugeführtes Signal, zu entzerrendes Signal |

**Patentansprüche**

1. Verfahren zur Decodierung eines zyklisch codierten als Datenwort (a(x)) vorliegenden Signals, welches Datenwort (a(x)) mittels einem Generatorpolynom (t(x)) codiert ist, wobei das Generatorpolynom aus dem Produkt eines ersten und eines zweiten Polynoms (f(x), g(x); (t(x) = f(x) · g(x)) gebildet wird, wobei durch die Codierung mit dem Generatorpolynom ein Codewort (c(x) = t(x) · a(x)) entsteht, zu dem das zweite Polynom (g(x)) hinzuaddiert wird, so dass ein geändertes Codewort (c'(x) = c(x) + g(x) = t(x) · a(x) + g(x)) entsteht und als Codewort (c'(x)) der Länge n Bit mehrfach in jeweils einem Taktzyklus übermittelt wird, **gekennzeichnet durch** die Verfahrensschritte;

   A die zuletzt übermittelten n Bits eines Codewortes (c'(x)) werden in einem Speicher (DM) abgelegt;
   B nach jedem Taktzyklus wird mit dem zweiten Polynom (g(x)) ein Syndrom ($S_{g1}$) aus den zuletzt übermittelten n Bits eines Codewortes (c'(x)) gebildet und gespeichert;
   C in jedem Taktzyklus wird die Differenz (DT) zwischen dem zuletzt und dem n Taktzyklen früher abgespeicherten Syndrom ($S_{g2}, .. , S_{g\,n+1}$) gebildet,
   D wenn die im Verfahrensschritt C gebildete Differenz (DT) gleich Null ist, werden die n im Speicher (DM) gespeicherten Bits zur Weiterverarbeitung ausgegeben.

2. Verfahren nach Anspruch 1, **gekennzeichnet durch** die Verfahrensschritte;

   BB nach jedem Taktzyklus wird mit dem ersten Polynom (g(x)) ein Syndrom ($S_{f1}$) aus den zuletzt übermittelten n Bits eines Codewortes (c'(x)) gebildet und gespeichert;
   CC in jedem Taktzyklus wird die Differenz zwischen dem zuletzt und dem n Taktzyklen früher abgespeicherten Syndrom ($S_{f2}, .. , S_{f\,n+1}$) gebildet,
   DD das erste und letzte je mit dem ersten Polynom (f(x)) gebildete Syndrom ($S_{f1}, S_{f\,n+1}$) werden verglichen (DT2) und mit einer festgestellten Differenz (fp) wird die Soll/Ist-Abweichung der Position eines erwarteten Fehlers innerhalb des gespeicherten Codewortes (c'(x)) festgestellt, wodurch das als Datenwort (a(x)) vorliegende Signal **durch** eine Synchronisation wieder korrekt zusammengefügt wird.

3. Verfahren nach Anspruch 1 oder 2, **dadurch gekennzeichnet, dass** im Verfahrensschritt B ein Syndromspeicher (SM) zur Speicherung von n+1 Syndromen vorgesehen ist.

4. Verfahren nach Anspruch 2 oder 3, **dadurch gekennzeichnet, dass** im Verfahrensschritt DD das gespeicherte Codewort (c'(x)) entsprechend der festgestellten Soll/Ist-Abweichung zyklisch verschoben wird, bis die übertragenen n Bit korrekt zusammengefügt sind.

**5.** Verfahren nach einem der Ansprüche 1 bis 4
**dadurch gekennzeichnet, dass**
das Datenwort (a(x)) als Codewort (c'(x)) in einem verkehrstechnischen Übertragungssystem zwischen einem Fahrzeug und einer Leitstelle übermittelt wird und sicherheitsrelevante Information beinhaltet.

**6.** System mit Mitteln zur Durchführung der Schritte des Verfahrens nach einem der Ansprüche 1 bis 5.

**Claims**

**1.** Method for decoding a cyclically coded signal which is present as a data word (a(x)), which data word (a(x)) is coded by means of a generator polynomial (t(x)), with the generator polynomial being formed from the product of a first and a second polynomial (f(x), g(x); (t(x) = f(x) · g(x)), with the coding by means of the generator polynomial producing a code word (c(x) = t(x) · a(x)) to which the second polynomial (g(x)) is added, with the result that a modified code word (c'(x) = c(x) + g(x) = t(x) · a(x) + g(x)) is generated and transmitted multiple times as a code word (c'(x)) with a length of n bits, each transmission taking place in a separate clock cycle,
**characterised by** the method steps:

A the most recently transmitted n bits of a code word (c'(x)) are stored in a memory (DM),
B after each clock cycle a syndrome ($S_{g1}$) is formed from the most recently transmitted n bits of a code word (c'(x)) by means of the second polynomial (g(x)) and stored,
C in each clock cycle the difference (DT) between the most recently stored syndrome and the syndrome stored n clock cycles earlier ($S_{g2}, .., S_{g\,n+1}$) is formed,
D if the difference (DT) formed in method step C is equal to zero, the n bits stored in the memory (DM) are output for further processing.

**2.** Method according to claim 1,
**characterised by** the method steps:

BB after each clock cycle a syndrome ($S_{f1}$) is formed from the most recently transmitted n bits of a code word (c'(x)) by means of the first polynomial (g(x)) and stored,
CC in each clock cycle the difference between the most recently stored syndrome and the syndrome stored n clock cycles earlier ($S_{f2}, .. , S_{f\,n+1}$) is formed,
DD the first and last syndrome ($S_{f1}, S_{f\,n+1}$), each formed by means of the first polynomial (f(x)), are compared (DT2) and the reference/actual deviation of the position of an expected error within the stored code word (c'(x)) is determined using a computed difference (fp), as a result of which the signal which is present as a data word (a(x)) is re-assembled correctly by means of a synchronisation.

**3.** Method according to claim 1 or 2,
**characterised in that**
in method step B a syndrome memory (SM) is provided for storing n+1 syndromes.

**4.** Method according to claim 2 or 3,
**characterised in that**
in method step DD the stored code word (c'(x)) is cyclically shifted in accordance with the computed reference/actual deviation until the transmitted n bits are correctly assembled.

**5.** Method according to one of the claims 1 to 4,
**characterised in that**
the data word (a(x)) is transmitted as a code word (c'(x)) in a traffic engineering transmission system between a vehicle and a control centre and contains security-related information.

**6.** System having means for performing the steps of the method according to one of the claims 1 to 5.

**Revendications**

**1.** Procédé pour décoder un signal codé cycliquement, présent sous forme de mot (a(x)) de données, ce mot (a(x)) de données étant codé au moyen d'un polynôme (t(x)) générateur, le polynôme générateur étant formé par le produit d'un premier et d'un second polynôme (f(x), g(x); (t(x) = f(x) · g(x)), étant créé par le codage par le polynôme générateur un mot (c(x) = t(x) · a(x)) de code, auquel on additionne le second polynôme (g(x)), si bien qu'un mot (c'(x) = c(x) + g(x) = t(x) a(x) + g(x)) de code modifié est créé et transmis comme mot (c'(x)) de code d'une longueur de n bits plusieurs fois dans un cycle d'horloge respectif,

  **caractérisé par** les étapes opératoires;

  A on met en mémoire dans une mémoire (DM) les n bits transmis en dernier d'un mot c'(x)) de code;
  B après chaque cycle d'horloge, on forme par le deuxième polynôme g(x)) un syndrome ($s_{g1}$) à partir des n bits transmis en dernier d'un mot c'(x)) de code et on le met en mémoire;
  C dans chaque cycle d'horloge, on forme la différence (DT) entre le syndrome ($s_{g2},..., S_{g\,n+1}$) mis en mémoire en dernier et le syndrome mis en mémoire n cycles d'horloge plus tôt,
  D si la différence (DT) formée à l'étape C opératoire est égale à zéro, on émet pour traitement ultérieur les n bits mis en mémoire dans la mémoire (DM).

2. Procédé suivant la revendication 1,
  **caractérisé par** les étapes opératoires;

  BB après chaque cycle d'horloge, on forme et on met en mémoire par le premier polynôme (g(x))un syndrome ($s_{f1}$) à partir des n bits transmis en dernier d'un mot (c'(x)) de code;
  CC dans chaque cycle d'horloge, on forme la différence entre le syndrome ($s_{f2}, ..., s_{f\,n+1}$) mis en mémoire en dernier et le syndrome mis en mémoire n cycles d'horloge plus tôt,
  DD on compare (DT2) le premier et le dernier syndrome ($s_{f1}, s_{f\,n+1}$) chaque fois formés par le premier polynôme (f(x)) et, par une différence (fp) fixée, on fixe l'écart consigne/réel de la position d'une erreur à laquelle on s'attend à l'intérieur du mot (c'(x)) de code mis en mémoire, ce qui fait que le signal présent sous forme de mot (a(x)) de données est assemblé à nouveau de manière correcte par une synchronisation.

3. Procédé suivant la revendication 1 ou 2,
  **caractérisé en ce que**
  il est prévu à l'étape B opératoire une mémoire (SM) de syndrome pour mettre en mémoire n+1 syndromes.

4. Procédé suivant la revendication 2 ou 3,
  **caractérisé en ce que**
  à l'étape DD opératoire, on décale cycliquement le mot (c'(x)) de code mis en mémoire en fonction de l'écart fixé consigne/réel jusqu'à ce que les n bits transmis soient assemblés correctement.

5. Procédé suivant l'une des revendications 1 à 4,
  **caractérisé en ce que**
  le mot (a(x)) de données est transmis sous forme de mot (c'(x)) de code dans un système de transmission de la technique des transports entre un véhicule et un poste de guidage et contient de l'information pertinente sur la sécurité.

6. Système comportant des moyens pour la mise en oeuvre des étapes du procédé suivant l'une des revendications 1 à 5.

**Fig. 1**

**Fig. 2**

**Fig. 3**

**Fig. 4**

**Fig. 5**

**Fig. 7**

11

**Fig. 6**